(19) Europäisches Patentamt
European Patent Office
Office européen des brevets

(11) **EP 4 509 645 A1**

(12) **EUROPEAN PATENT APPLICATION**
published in accordance with Art. 153(4) EPC

(43) Date of publication:
**19.02.2025 Bulletin 2025/08**

(21) Application number: 23788038.0

(22) Date of filing: **22.02.2023**

(51) International Patent Classification (IPC):
*C30B 25/18* (2006.01)     *C30B 29/06* (2006.01)
*C30B 29/38* (2006.01)     *C30B 33/06* (2006.01)
*H01L 21/20* (2006.01)     *H01L 21/205* (2006.01)

(52) Cooperative Patent Classification (CPC):
**C30B 25/18; C30B 29/06; C30B 29/38;
C30B 33/06; H01L 21/20; H01L 21/2015**

(86) International application number:
**PCT/JP2023/006579**

(87) International publication number:
**WO 2023/199616 (19.10.2023 Gazette 2023/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.04.2022 JP 2022066618
27.09.2022 JP 2022153842**

(71) Applicant: **Shin-Etsu Handotai Co., Ltd.
Tokyo 100-0004 (JP)**

(72) Inventors:
• **HAGIMOTO, Kazunori**
  **Annaka-shi, Gunma 379-0196 (JP)**
• **SUGAWARA, Kosei**
  **Nishishirakawa-gun, Fukushima 961-8061 (JP)**
• **TANAKA, Yuki**
  **Nishishirakawa-gun, Fukushima 961-8061 (JP)**
• **AGA, Hiroji**
  **Annaka-shi, Gunma 379-0196 (JP)**

(74) Representative: **Mooser, Sebastian Thomas
Wuesthoff & Wuesthoff
Patentanwälte und Rechtsanwalt PartG mbB
Schweigerstraße 2
81541 München (DE)**

(54) **SUBSTRATE FOR ELECTRONIC DEVICES AND METHOD FOR PRODUCING SAME**

(57)     The present invention is a substrate for an electronic device, comprising a nitride semiconductor film formed on a bonded substrate comprising a silicon single crystal, wherein the bonded substrate is a substrate comprising a first silicon single-crystal substrate having a crystal plane orientation of {111} and a second silicon single-crystal substrate having a main surface that has an off-angle with respect to a crystal plane orientation of {100}, the first silicon single-crystal substrate and the second silicon single-crystal substrate being bonded via an oxide film, and the nitride semiconductor film is formed on a surface of the first silicon single-crystal substrate of the bonded substrate. This provides a substrate for an electronic device, including a nitride semiconductor formed on a silicon single-crystal, which is the substrate for the electronic device with the suppressed generation of slips, cracks, etc., and with a high breaking strength, and provides a method for producing the substrate.

[FIG. 1]

# EP 4 509 645 A1

## Description

### TECHNICAL FIELD

The present invention relates to a substrate for an electronic device and a method for producing the same, in particular, a substrate for an electronic device where a nitride semiconductor is formed on a silicon substrate and a method for producing the same.

### BACKGROUND ART

Nitride semiconductors, including GaN and AlN, can be used for fabricating high electron mobility transistors (HEMT) that uses two-dimensional electron gas and electronic devices with a high breakdown voltage.

It is difficult to produce a nitride semiconductor wafer having a nitride semiconductor grown on a substrate, and a sapphire substrate or a SiC substrate is conventionally used as a growth substrate. However, in order to achieve a larger diameter substrate (diameter enlargement) and suppress costs for a substrate, epitaxial growth of a nitride semiconductor by vapor phase growth on a silicon single-crystal substrate has been employed. When an epitaxially grown film of the nitride semiconductor is produced by vapor phase growth on a silicon single-crystal substrate, a substrate with a larger diameter can be used compared to a sapphire substrate or a SiC substrate; thus, the productivity of devices is high and processing is easy, and therefore there are advantages. However, due to stress caused by a difference in lattice constant or a difference in thermal expansion coefficient, an increase in warps, slips, cracks, and the like easily occurs at the vapor phase growth of the nitride semiconductor on the silicon single-crystal substrate. Therefore, stress reduction is carried out through growth conditions and a relief layer.

In particular, in order to make epitaxial substrates for power devices to have high breakdown voltage, it is necessary to produce GaN on Si (GaN on a silicon single-crystal) in which an epitaxial layer of GaN has increased thickness. To increase the thickness of the epitaxial layer, the silicon single-crystal substrate, being the growth substrate, may be thickened and epitaxial growth may be performed. In addition, as a method to thicken the silicon single-crystal substrate, bonding of two silicon single-crystal substrates has been conducted. Patent Document 1 discloses the thickness of a bonded substrate of 2 mm or more. Moreover, Patent Document 2 discloses a combination of two substrates to be bonded, including a bond wafer having a plane orientation of {111} and a base wafer having a plane orientation of {100} and a resistivity of 0.1 Qcm or less.

### CITATION LIST

### PATENT LITERATURE

Patent Document 1: JP 2021-014376 A
Patent Document 2: JP 2021-027186 A

### SUMMARY OF INVENTION

### TECHNICAL PROBLEM

As described above, the use of bonded substrates as growth substrates is known as disclosed in Patent Document 1 and Patent Document 2. However, even if these bonded substrates are used, it has not been possible to completely suppress an increase in warps and generation of slips, cracks, and the like. Moreover, the slips, the cracks, and the like have often been generated mainly at a notch portion of the substrates. Generally, the notch is formed in <110> direction on the {111} silicon single-crystal substrate and formed in <110> direction or <100> direction on a {100} silicon single-crystal substrate.

The present invention has been made to solve the above-described problem. An object of the present invention is to provide a substrate for an electronic device, including a nitride semiconductor formed on a silicon single-crystal, which is the substrate for the electronic device with the suppressed generation of the slips, the cracks, etc., and with high breaking strength, and a method for producing the substrate.

### SOLUTION TO PROBLEM

To solve the problem described above, the present invention provides a substrate for an electronic device,

2

comprising a nitride semiconductor film formed on a bonded substrate comprising a silicon single crystal, wherein

the bonded substrate is a substrate comprising a first silicon single-crystal substrate having a crystal plane orientation of {111} and a second silicon single-crystal substrate having a main surface that has an off-angle with respect to a crystal plane orientation of {100}, the first silicon single-crystal substrate and the second silicon single-crystal substrate being bonded via an oxide film, and
the nitride semiconductor film is formed on a surface of the first silicon single-crystal substrate of the bonded substrate.

With regard to the crystal plane orientation, a cleavage plane with respect to the main surface (a bonding surface with the first silicon single-crystal substrate) is nonvertical (the cleavage plane is tilted) by providing the off-angle as in the second silicon single-crystal substrate of the present invention, instead of a just-crystal-plane-orientation substrate without the off-angle like a conventional second silicon single-crystal substrate. In this way, the cleavage plane being tilted of just one second silicon single-crystal substrate can make the substrate for the electronic device with a high breaking strength, in which an increase in warps and generation of slips, cracks (hereinafter also referred to as cracks, etc.) are suppressed compared with a conventional substrate where the cleavage plane of the second silicon single-crystal substrate is also vertical to a bonding surface.

In this case, the second silicon single-crystal substrate can be nitrogen-doped.

Such a substrate serves as the substrate for the electronic device having higher breaking strength.

In addition, it is possible that the first silicon single-crystal substrate is formed with a notch in <110> direction,

the second silicon single-crystal substrate is formed with a notch in <110> direction, and
the bonded substrate is a substrate bonded to align a notch position of the first silicon single-crystal substrate and a notch position of the second silicon single-crystal substrate.

Such a substrate serves as the substrate for an electronic device, with further suppressed generation of the cracks, etc., and with high breaking strength, due to a positional relationship between the cleavage planes of the to-be-bonded first silicon single-crystal substrate and the to-be-bonded second silicon single-crystal substrate.
the bonded substrate can have a diameter of 300 mm or larger.

Thus, the substrate having the high breaking strength of the present invention is particularly effective for the substrate for the electronic device having a large diameter, such as a diameter of 300 mm or larger.

Moreover, the present invention provides a method for producing a substrate for an electronic device by forming a nitride semiconductor film on a bonded substrate comprising a silicon single crystal, the method comprising the steps of:

preparing a first silicon single-crystal substrate having a crystal plane orientation of {111}, and a second silicon single-crystal substrate having a main surface that has an off-angle with respect to a crystal plane orientation of {100};
thermally oxidizing at least one of the first silicon single-crystal substrate and the second silicon single-crystal substrate to form an oxide film on a surface;
producing the bonded substrate by laminating the first silicon single-crystal substrate and the second silicon single-crystal substrate via the oxide film and then heat treating to bond the first silicon single-crystal substrate and the second silicon single-crystal substrate; and
epitaxially growing the nitride semiconductor film on a surface of the first silicon single-crystal substrate of the bonded substrate.

According to such an inventive method for producing the substrate for an electronic device, the second silicon single-crystal substrate having the cleavage plane tilted to the bonding surface is included, and thus, the substrate for the electronic device with suppressed generation of the cracks, etc., and with high breaking strength can be produced.

In this case, the second silicon single-crystal substrate to be prepared can be nitrogen-doped.

In this way, the substrate for the electronic device having higher breaking strength can be produced.

Moreover, it is possible that the first silicon single-crystal substrate to be prepared is formed with a notch in <110> direction,

the second silicon single-crystal substrate to be prepared is formed with a notch in <110> direction, and
the first silicon single-crystal substrate and the second silicon single-crystal substrate are laminated and bonded so as to align a notch position of the first silicon single-crystal substrate and a notch position of the second silicon single-crystal substrate.

In such a way, it is possible to produce the substrate for the electronic device with further suppressed generation of the cracks, etc., and with high breaking strength due to a positional relationship between the cleavage planes of the to-be-bonded first silicon single-crystal substrate and the to-be-bonded second silicon single-crystal substrate.

Moreover, the first silicon single-crystal substrate and the second silicon single-crystal substrate to be prepared can have diameters of 300 mm or larger.

The substrate having a high breaking strength, such as the substrate for the electronic device produced by the inventive producing method, is particularly effective for producing the substrate for the electronic device having a large diameter, such as a diameter of 300 mm or larger.

ADVANTAGEOUS EFFECTS OF INVENTION

According to such an inventive substrate for the electronic device and the method for producing the same, since the second silicon single-crystal substrate has an off-angle and a cleavage plane tilted to the bonding surface, and thus, the substrate for the electronic device with the suppressed generation of the cracks, etc., and with high breaking strength can be provided.

BRIEF DESCRIPTION OF DRAWINGS

FIG. 1 is a schematic cross-sectional view illustrating an example of a substrate for an electronic device according to the present invention.
FIG. 2 is an explanatory view illustrating an example of a positional relationship between a cleavage plane in a first silicon single-crystal substrate and a cleavage plane in a second silicon single-crystal substrate.
FIG. 3 is a schematic view illustrating an example of cleavage planes of a first silicon single-crystal substrate and a second silicon single-crystal substrate viewed from a main surface side.
FIG. 4 is a schematic view illustrating another example of cleavage planes of a first silicon single-crystal substrate and a second silicon single-crystal substrate viewed from a main surface side.
FIG. 5 is a flowchart illustrating a schematic of an example of a method for producing a substrate for an electronic device according to the present invention.
FIG. 6 is a photograph of a state in which a bonded substrate is mounted in a wafer box after removing an oxide film in Example and Comparative Example.
FIG. 7 is a schematic view illustrating a state of breaking load test and bending strength test. (a) View from above in a vertical direction. (b) View from side.

DESCRIPTION OF EMBODIMENTS

Hereinafter, the present invention is described in detail with referring to the drawings. However, the present invention is not limited thereto.

[Substrate for Electronic Device]

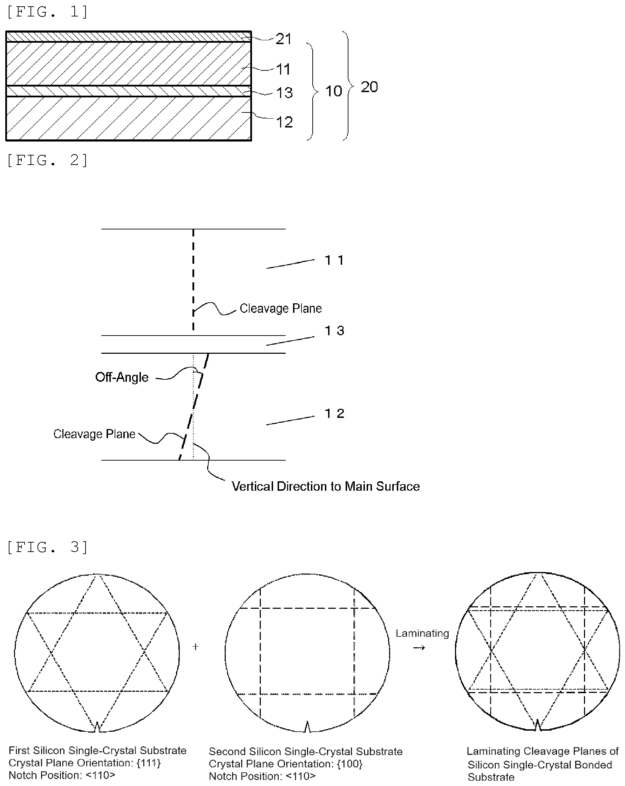

As shown in FIG. 1, in the inventive substrate for an electronic device 20, a nitride semiconductor film 21 is formed on a silicon single-crystal bonded substrate 10. In the description of the present invention, the silicon single-crystal bonded substrate 10 is also referred to simply as "bonded substrate." In this case, the bonded substrate 10 is a substrate in which a first silicon single-crystal substrate 11 having a crystal plane orientation of {111} and a second silicon single-crystal substrate 12 having a main surface that has an off-angle with respect to a crystal plane orientation of {100} are bonded via an oxide film 13. As shown in FIG. 1, the nitride semiconductor film 21 is formed on the first silicon single-crystal substrate 11.

Note that, in this description, a line above the number commonly used in the Miller index notation is substituted by a "-" in front of a number. That is, for example, the notation [1-10] is synonymous with:

$$\left[\, 1\, \overline{1}\, 0\, \right]$$

Miller index notations are used in the usual way. That is, {} means a general term for equivalent crystal plane orientations, and () means each direction of the crystal plane orientations. In addition, <> indicates a general term for equivalent crystal axis directions, and [] means each direction of crystal axis directions.

As described above; in order to make epitaxial substrates for power devices have high breakdown voltage, it is necessary to produce a substrate for an electronic device formed with a thick nitride semiconductor film on a silicon single-crystal substrate (for example, GaN on Si in which an epitaxial layer of GaN has increased thickness). To increase the thickness of the epitaxial layer, the silicon single-crystal substrate may be thickened and epitaxial growth may be performed. In addition, as a method to thicken the silicon substrate, bonding of two silicon single-crystal substrates has been conducted; however, even if the bonded substrate is used, a complete suppression of the cracks, etc., has not been achieved.

However, in the inventive substrate for the electronic device 20, as described above, two silicon single-crystal substrates, the first and second silicon single-crystal substrates 11 and 12, being bonded, are used as an underlying substrate (seed crystal) (bonded substrate 10); moreover, in the second silicon single-crystal substrate 12 among them, the main surface has the off-angle with respect to the crystal plane orientation of {100}, thus a cleavage plane is nonvertical with respect to a bonding surface with the first silicon single-crystal substrate. In this case, when compared with a conventional substrate using a just-crystal-plane-orientation substrate without the off-angle, the substrate for the electronic device can be made with suppressed generation of the crack, etc. (increased warps, or slips, cracks) and with high breaking strength.

FIG. 2 shows an example of a positional relationship between the cleavage plane in the first silicon single-crystal substrate 11 and the cleavage plane in the second silicon single-crystal substrate 12. Note that although a case where these cleavage planes are in close positions with each other in a vertical direction to the main surface is described as an example here (that is, the positions are close in planar view), the present invention is not limited to such a positional relationship. Moreover, a case having the off-angle in the left-and-right direction on a paper is given as an example in FIG. 2, the direction of the off-angle is not particularly limited in the present invention. That is, regardless of the positions of the cleavage planes between the first silicon single-crystal substrate 11 and the second silicon single-crystal substrate 12 in a planar view being close or distant from each other; moreover, regardless of the direction of the off-angle direction of the second silicon single-crystal substrate 12 (e.g., even the front-and-back direction on paper in FIG. 2), the above-described effect of preventing the cracks, etc., can be achieved.

In contrast, when both substrates are just-crystal-plane-orientation substrates without the off-angle; the cracks, etc., are prone to be generated.

The size of the off-angle is not particularly limited but can be, for example, more than 0° and 12° or less, preferably from 2° to 8°, particularly 4°.

Note that, in the present invention, each position of forming notch of the first silicon single-crystal substrate 11 and the second silicon single-crystal substrate 12 is not particularly limited.

In an example described below, the first silicon single-crystal substrate 11 is formed with the notch in <110> direction, and the second silicon single-crystal substrate 12 is formed with the notch in <110> direction. Moreover, the bonded substrate 10 is bonded so as to align the notch position of the first silicon single-crystal substrate 11 and the notch position of the second silicon single-crystal substrate 12.

In such a case, in addition to obtaining the above-mentioned off-angle effect (improvement of the breaking strength), the breaking strength can be further improved by the positional shift between the cleavage planes of the first silicon single-crystal substrate and the second silicon single-crystal substrate in the planar view.

More specifically, a state of bonding of the first silicon single-crystal substrate 11 and the second silicon single-crystal substrate 12, as described above, is described by referring to FIG. 3, a drawing seen from the main surface (main front surface) side of each substrate. In this context, an example in which the substrate having the crystal plane orientation of {111} and the notch at <110> position is the first silicon single-crystal substrate 11 and the substrate having the crystal plane orientation of {100} and the notch at <110> position is the second silicon single-crystal substrate 12, is described.

In FIG. 3, the cleavage plane of the first silicon single-crystal substrate 11 is schematically shown by a dotted line, and the cleavage plane of the second silicon single-crystal substrate 12 is schematically shown by a dashed line, respectively. As shown in FIG. 1, when the first silicon single-crystal substrate 11 and the second silicon single-crystal substrate 12 are laminated, it is found that cleavage planes in the vertical direction of the drawing are shifted. The cleavage planes in the lateral direction of the drawing are overlapped. However, as for the entire bonded substrate 10, the effect of the shift of the cleavage planes in the vertical direction of the drawing improves the substrate strength of the bonded substrate 10. As a result, even in the presence of the nitride semiconductor film 21 formed on a surface of the first silicon single-crystal substrate 11 of the bonded substrate 10, the substrate for the electronic device 20 can be made with the further suppressed generation of the cracks, etc., and with high breaking strength.

Moreover, in the inventive substrate for the electronic device 20, the nitride semiconductor film 21 is formed on the surface of the first silicon single-crystal substrate 11 having the crystal plane orientation of {111}, thus the excellent nitride semiconductor film 21 is formed.

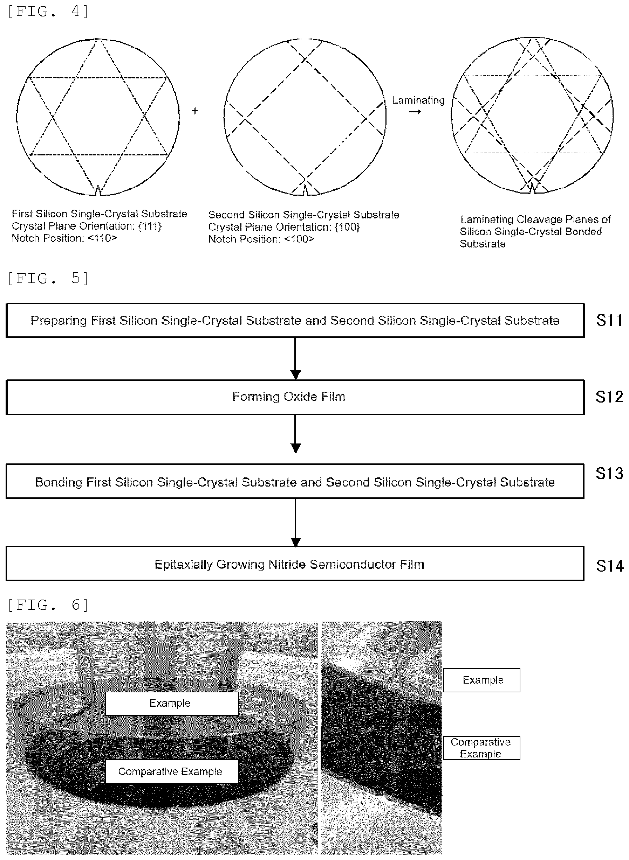

In FIG. 4, an example of another bonded substrate is shown. In FIG. 4, an example in which the substrate having the crystal plane orientation of {111} and the notch at <110> position is the first silicon single-crystal substrate and the substrate having the crystal plane orientation of {100} and the notch at <100> position is the second silicon single-crystal substrate, is described. In this case, although the crystal axis direction of the formed notch of the second silicon single-crystal substrate differs from the case in FIG. 3, others are the same as in FIG. 3. As can be seen in FIG. 4, when the first silicon single-crystal substrate 11 and the second silicon single-crystal substrate 12 are laminated, the cleavage planes are all in close proximity to each other. Even in a case like FIG. 4, because two silicon single-crystal substrates with crystal plane orientations of {111} and {100}, respectively, are bonded, and the second silicon single-crystal substrate 12 has the above off-angle, thus the strength of the bonded substrate and the substrate for the electronic device is enhanced, but the case in FIG. 3 has more enhanced strength than the case in FIG. 4.

In the inventive substrate for the electronic device 20, the diameter of the bonded substrate 10 (and the substrate for the electronic device 20) can also be made as a large diameter of 300 mm or larger because of the high substrate strength as described above. Conventionally, the substrate having such a large diameter has a case where the substrate strength is insufficient, and the cracks, etc., are generated; however, the inventive substrate for the electronic device can be made with high breaking strength, which suppresses these factors. The upper limit of the diameter of the bonded substrate 10 (and the substrate for the electronic device 20) is not particularly limited but can be, for example, 450 mm or smaller.

When the diameter of the bonded substrate 10 (and the substrate for the electronic device 20) is 300 mm or larger, the diameters of the first silicon single-crystal substrate 11 and the second silicon single-crystal substrate 12 are also 300 mm or larger. The respective thickness of the first silicon single-crystal substrate 11 and the second silicon single-crystal substrate 12 is not particularly limited but can be suitably used in accordance with standards. In particular, when the diameter is 300 mm, the thickness can be 775 um. Such a silicon single-crystal substrate is used as a general substrate for a device, is inexpensive, and can be used without particular problems. As the thickness of the first silicon single-crystal substrate 11 and the second silicon single-crystal substrate 12, the substrate having a thickness of 500 $\mu$m to 1500 um can be used, for example.

Moreover, the second silicon single-crystal substrate 12 can be nitrogen-doped. The strength of the second silicon single-crystal substrate 12 is further enhanced by nitrogen doping, resulting in the substrate for the electronic device 20 with even higher breaking strength. The concentration of nitrogen is not particularly limited but can be, for example, $5 \times 10^{13}$ to $5 \times 10^{15}$ atoms/cm$^3$.

[Method for Producing Substrate for Electronic Device]

Hereinafter, a method for producing the inventive substrate for the electronic device 20 described above is described referring to FIG. 5.

Firstly, as shown in S11 of FIG. 5, a first silicon single-crystal substrate 11 and a second silicon single-crystal substrate 12 are prepared (Step S11). In this case, a silicon single-crystal substrate having a crystal plane orientation of {111} and a notch formed in <110> direction is prepared as the first silicon single-crystal substrate 11. In addition, a silicon single-crystal substrate having a main surface that has an off-angle with respect to a crystal plane orientation of {100}, and a notch formed in <110> direction is prepared as the second silicon single-crystal substrate 12.

Note that in preparing the second silicon single-crystal substrate 12 having the off-angle described above, such a substrate can be obtained, for example, by producing a single ingot having a growth axis direction of <100> and slicing thereof at a desired off-angle.

In this case, the diameters of the first silicon single-crystal substrate to be prepared and the second silicon single-crystal substrate to be prepared can be 300 mm or larger.

Moreover, as the second silicon single-crystal substrate, in particular, the substrate can be nitrogen-doped. A method for nitrogen doping is not particularly limited, but a known method can be used. For example, in producing a silicon single crystal by a CZ method, a silicon ingot, nitrogen-doped by using a silicon wafer having a nitrogen film and the like as raw material, can be produced and cut out. Naturally, the first silicon single-crystal substrate may also be nitrogen-doped.

Moreover, the first silicon single-crystal substrate 11 and the second silicon single-crystal substrate 12 are bonded to make a bonded substrate 20, which is one silicon single-crystal substrate, so the first silicon single-crystal substrate 11 can be referred to as a bond wafer, and the second silicon single-crystal substrate 12 can be referred to as a base wafer.

The respective thickness of the first silicon single-crystal substrate 11 and the second silicon single-crystal substrate 12 is not particularly limited but can be suitably used in accordance with standards. Moreover, the respective resistivity and impurity concentration of the first silicon single-crystal substrate 11 and the second silicon single-crystal substrate 12 can be determined as appropriate.

Next, as shown in S12 of FIG. 5, at least one of the first silicon single-crystal substrate 11 and the second silicon single-crystal substrate 12 is thermally oxidized to form an oxide film on a surface (Step S12). The oxide film formed here is a film to be an oxide film 13, as shown in FIG. 1 after bonding of both silicon single-crystal substrates. The forming method of this oxide film is not particularly limited, but, for example, the oxide film having a thickness of about 100 nm can be formed on the surface of the substrate by an oxidation heat treatment. The thickness of the oxide film is not particularly limited but, for example, can be 10 nm or more and 1000 nm or less. The oxide film may be formed on each of two silicon single-crystal substrates, or the oxide film may be formed on any one of silicon single-crystal substrates.

Next, as shown in S13 of FIG. 5, the first silicon single-crystal substrate 11 and the second silicon single-crystal substrate 12 are bonded (Step S13). In this case, firstly, it is preferred that the first silicon single-crystal substrate 11 and the second silicon single-crystal substrate 12 are laminated so as to align a notch position the first silicon single-crystal substrate 11 and a notch position of the second silicon single-crystal substrate 12. In that case, both silicon single-crystal substrates are laminated via the oxide film formed in Step S12. By performing heat treatment in this state, the first silicon single-crystal substrate 11 and the second silicon single-crystal substrate 12 are bonded to produce the bonded substrate 10 (see FIG. 1).

Conditions (atmosphere, temperature, time, and the like) for the heat treatment (bonding heat treatment) are not particularly limited as long as the first silicon single-crystal substrate 11 and the second silicon single-crystal substrate 12 can be bonded. The temperature of the bonding heat treatment can be, for example, at 400°C or higher and 1200°C or lower in a nitrogen atmosphere for 1 to 12 hours.

After this bonding heat treatment, it is preferred to clean a surface of the bonded substrate 10 before the epitaxial growth of a nitride semiconductor film described later. In particular, it is preferred to remove the oxide film generated on the surface of the bonded substrate 10 (in particular, the surface of the first silicon single-crystal substrate 11) by hydrofluoric acid spin cleaning, etc.

In this way, after the bonding of the first silicon single-crystal substrate 11 and the second silicon single-crystal substrate 12 to produce the bonded substrate 10, the nitride semiconductor film 21 (see FIG. 1) is epitaxially grown on the surface of the first silicon single-crystal substrate 11 of the bonded substrate 10 (Step S14), as shown in S14 of FIG. 5. Note that regarding the first silicon single-crystal substrate 11, double-side polishing may be performed before this bonding, or even if not double-side polished before bonding, the main surface to be grown can be single-sided polished after bonding and before epitaxial growth. Naturally, regarding the second silicon single-crystal substrate 12, the double-side polishing may also be performed.

As the nitride semiconductor film 21, an AlN layer, a GaN layer, an AlGaN layer, and the like can be formed. This nitride semiconductor film 21 can be formed by a common method. Moreover, an intermediate layer (buffer layer) can be formed as appropriate. In this way, the substrate for the electronic device 20 shown in FIG. 1 can be produced.

EXAMPLE

Hereinafter, the present invention will be more specifically described showing Examples and Comparative Examples. However, the present invention is not limited to Example described below.

(Example 1)

In accordance with the inventive method for producing a substrate for an electronic device shown in FIG. 5, a substrate for an electronic device 20 shown in FIG. 1 was produced.

Firstly, as a first silicon single-crystal substrate 11, a double-side polished silicon single-crystal substrate having a diameter of 300 mm, a thickness of 775 $\mu$m, a crystal plane orientation of {111}, p-type, and resistivity of 1 kS2cm with a notch formed in <110> direction was prepared; and as a second silicon single-crystal substrate 12, a double-side polished silicon single-crystal substrate having a diameter of 300 mm, a thickness of 775 $\mu$m, a crystal plane orientation of {100}, p-type, and resistivity of 30 $\Omega$cm with a notch formed in <110> direction was prepared (Step S11).

This first silicon single-crystal substrate 11 and second silicon single-crystal substrate 12 had cleavage planes, respectively, as shown in FIG. 3 as a schematic view.

Note that with regard to the crystal plane orientation, the first silicon single-crystal substrate 11 had a just-crystal-plane-orientation without an off-angle, and the second silicon single-crystal substrate 12 had a crystal plane orientation with an off-angle (4°). The direction of the off-angle was set in the opposite direction to the notch (0 o'clock direction in FIG. 3).

Moreover, the first silicon single-crystal substrate 11 was not nitrogen-doped, the second silicon single-crystal substrate 12 was nitrogen-doped, and nitrogen concentration was $5 \times 10^{13}$ atoms/cm$^3$.

These prepared two silicon single-crystal substrates were processed with oxidation heat treatment to form an oxide film having a thickness of 100 nm, respectively (Step S12).

Next, two silicon single-crystal substrates were bonded with aligning the notch positions, and then bonding heat treatment at 500°C in a nitrogen atmosphere was performed to produce a bonded substrate 10 (Step S13). Subsequently, hydrofluoric acid spin cleaning was performed on the bonded substrate 10 to remove the oxide film on the surface. Note that FIG. 6 shows a state where the substrate, after removing the oxide film, was mounted in a wafer BOX.

Next, an AlN layer of 150 nm, an AlGaN layer of 160 nm, a superlattice structure with 25 alternating pairs of GaN layers and AlN layers being laminated, a GaN layer of 1000 nm, an AlGaN layer of 20 nm, and a GaN layer of 3 nm were epitaxially grown to a total thickness of 1.8 um on the surface of the first silicon single-crystal substrate 11 of the bonded substrate 10 as a nitride semiconductor film 21 (Step S14).

As a result, GaN was successfully formed without the generation of cracks or slips. Consequently, the substrate for electronic device 20 was produced.

(Comparative Example 1)

As described below, a substrate for an electronic device was produced in the same way as in Example 1, except that a just-crystal-plane-orientation substrate without an off-angle unlike Example 1, was used as a second silicon single-crystal substrate.

Firstly, as a first silicon single-crystal substrate, a double-side polished silicon single-crystal substrate having a diameter of 300 mm, a thickness of 775 μm, a crystal plane orientation of {111}, p-type, and resistivity of 1 kΩcm with a notch formed in <110> direction was prepared; and as a second silicon single-crystal substrate, a double-side polished silicon single-crystal substrate having a diameter of 300 mm, a thickness of 775 μm, a crystal plane orientation of {100}, p-type, and resistivity of 30 Ωcm with a notch formed in <110> direction was prepared.

This first silicon single-crystal substrate and second silicon single-crystal substrate had cleavage planes, respectively, as shown in FIG. 3 as a schematic view.

Note that with regard to the crystal plane orientation, not only the first silicon single-crystal substrate but also the second silicon single-crystal substrate had a just-crystal-plane-orientation without an off-angle.

Moreover, the first silicon single-crystal substrate was not nitrogen-doped, the second silicon single-crystal substrate was nitrogen-doped, and nitrogen concentration was $5 \times 10^{13}$ atoms/cm$^3$.

These provided two silicon single-crystal substrates were processed with oxidation heat treatment to form an oxide film having a thickness of 100 nm, respectively.

Next, two silicon single-crystal substrates were bonded with aligning the notch positions, and then bonding heat treatment at 500°C in a nitrogen atmosphere was performed to produce a bonded substrate. Note that this heat treatment process was performed simultaneously with the bonding heat treatment process in Example 1, as shown in FIG. 6. Subsequently, hydrofluoric acid spin cleaning was performed on the bonded substrate 10 to remove the oxide film on the surface. Note that the substrate, after removing the oxide film, was mounted in a wafer BOX (see FIG. 6).

Next, a GaN film was epitaxially grown as a nitride semiconductor film on a surface of the first silicon single-crystal substrate of the bonded substrate on the same condition as in Example 1.

As a result, although slip, etc., was not generated, breaking strength was inferior to Example 1, as described later.

Hereinafter, the bonded substrates before forming the nitride semiconductor films were produced on the same conditions as in each of Example 1 and Comparative Example 1, and the strength of each bonded substrate was measured.

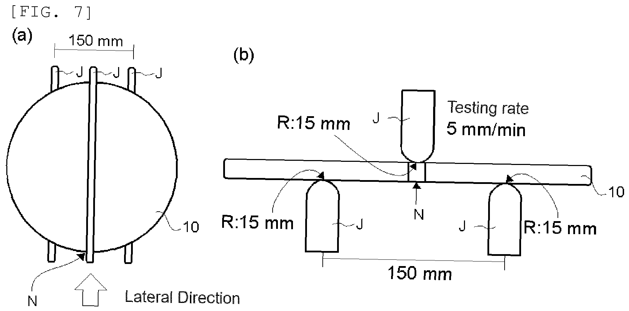

In this strength measurement of the bonded substrate, as shown in FIG. 7, breaking load and bending strength were investigated using a Universal Testing System manufactured by INSTRON Corporation. FIG. 7 (a) is a top view from the vertical direction, and FIG. 7 (b) is a side view.

As shown in FIGs. 7 (a) and (b), three fulcrum jigs J (curvature radius R of crimping points is 15 mm) were arranged above and below the bonded substrate. In the bonded substrate, the notch position was weak in terms of strength, thus, the notch position N was arranged to be just below the central fulcrum jig J (see FIGS. 7 (a) and (b)). The formula for the bending strength is as follows.

$$\text{Bending strength} = 3PL \ / \ 2WT^2 \ (\text{Formula})$$

P: Breaking load,

$$L = \text{Span between fulcrums (150 mm)}$$

W: Width 300 mm
T: Thickness 1.55 mm

As a result, the breaking load of the notch portion of the bonded substrate 10 in Example 1 was 784 N, and the bending strength thereof was 245 Mpa. On the other hand, the breaking load of the notch portion of the bonded substrate in Comparative Example 1 was 732 N and the bending strength thereof was 228 Mpa. Consequently, it was found that the bonded substrate 10 in Example 1 had higher breaking strength than that of Comparative Example 1.

(Example 2, Comparative Example 2)

A substrate for an electronic device was produced in the same way as in Example 1, except that a second silicon single-crystal substrate, being not nitrogen-doped unlike Example 1, was used (Example 2). As a result, GaN was successfully formed without generation of cracks and slips.

Moreover, a substrate for an electronic device was produced in the same way as in Comparative Example 1, except that a second silicon single-crystal substrate, not nitrogen-doped unlike Comparative Example 1, was used (Comparative Example 2). As a result, slip, etc., was not generated, but breaking strength was inferior compared with Example 2, as described later.

In addition, based on the same conditions as in each of Example 2 and Comparative Example 2, bonded substrates before forming nitride semiconductor films were produced, and the strength of each bonded substrate was measured. The measuring method was the same as in Example 1 and Comparative Example 1.

As a result, the breaking load of the notch portion of the bonded substrate 10 in Example 2 was 713 N, and the bending strength thereof was 223 Mpa. On the other hand, the breaking load of the notch portion of the bonded substrate in Comparative Example 2 was 663 N and the bending strength thereof was 207 Mpa. Consequently, it was found that the bonded substrate 10 in Example 2 had higher breaking strength than that of Comparative Example 2.

The results of the above breaking load and bending strength are summarized in Table 1.

[Table 1]

|  | Nitrogen doping | Off | Breaking Load N | Bending Strength MPa |
|---|---|---|---|---|
| Example 1 | Present | 4° off | 784 | 245 |
| Comparative Example 1 | Present | just | 732 | 228 |
| Example 2 | Absent | 4° off | 713 | 223 |
| Comparative Example 2 | Absent | just | 663 | 207 |

As described above, or as can be seen from Table 1, in cases where nitrogen doping was present (Example 1 and Comparative Example 1), Example 1, in which the present invention was performed, exhibited more excellent results in the breaking load and the bending strength than Comparative Example 1. Moreover, even in cases where nitrogen doping was absent (Example 2 and Comparative Example 2), Example 2, in which the present invention was performed, exhibited more excellent results than Comparative Example 2.

Note that Comparative Example 1 exhibited better values than Example 2 but this is due to the difference between the presence and absence of nitrogen doping. When conditions other than the off-angle, such as the presence or absence of nitrogen doping, are the same condition, and when the second silicon single-crystal substrate has the off-angle as in the present invention, it is clear from the results described above that such a substrate is more excellent than a substrate without off-angle, in terms of the breaking load and the bending strength, and extremely effective in suppressing conventional problems such as increase of warps or cracks.

(Example 3-6)

Substrates for an electronic device were produced in the same way as in Example 1, except that second silicon single-crystal substrates having off-angles of 2° (Example 3) and that of 8° (Example 4), unlike Example 1 were used.

Moreover, substrates for an electronic device were produced in the same way as in Example 2, except that second silicon single-crystal substrates having off-angles of 2° (Example 5) and that of 8° (Example 6) unlike Example 2, were used.

As a result, GaN was successfully formed without generation of cracks or slips in each case.

In addition, based on the same condition as in each of Examples 3 to 6, bonded substrates before forming nitride semiconductor films were produced, and the strength of each bonded substrate was measured. The measuring method was the same as in Example 1.

As a result, the breaking load and the bending strength of the notch portions of the bonded substrates 10 in Examples 3 to 6 were (753 N, 235 MPa), (803 N, 251 MPa), (697 N, 218 MPa), and (731 N, 228 MPa).

Consequently, it was found that the bonded substrates 10 in Examples 3 and 4 had higher breaking strength than that of Comparative Example 1. Moreover, it was found that the bonded substrates 10 in Examples 5 and 6 had higher breaking strength than that of Comparative Example 2.

The results of the breaking load and bending strength in Examples 3 to 6 are summarized in Table 2.

[Table 2]

|  | Nitrogen doping | Off | Breaking Load N | Bending Strength MPa |
|---|---|---|---|---|
| Example 3 | Present | 2° off | 753 | 235 |
| Example 4 | Present | 8° off | 803 | 251 |
| Example 5 | Absent | 2° off | 697 | 218 |
| Example 6 | Absent | 8° off | 731 | 228 |

As described above, or as can be seen from Tables 1 and 2, in cases where nitrogen doping was present (Examples 3 and 4, and Comparative Example 1), Examples 3 and 4, in which the present invention was performed, exhibited more excellent results in the breaking load and the bending strength than Comparative Example 1. Moreover, even in cases where nitrogen doping was absent (Examples 5 and 6, and Comparative Example 2), Examples 5 and 6, in which the present invention was performed, exhibited more excellent results than Comparative Example 2.

Furthermore, as can be seen from comparisons within Examples 1, 3, and 4 and comparisons within Examples 2, 5, and 6, the larger the off-angle, the better the breaking strength result.

Note that although Comparative Example 1 exhibited better values than or equivalent to Examples 5 and 6, this is because of the same reason when Comparative Example 1 was compared with Example 2, which is the difference between the presence and absence of nitrogen doping. When conditions other than the off-angle are the same condition, the case where the second silicon single-crystal substrate has the off-angle, as in the present invention, has higher breaking strength than the case where the off-angle is absent and can be utilized in suppressing the increase of warps or cracks.

This description encompasses the following aspects.

[1]: A substrate for an electronic device, comprising a nitride semiconductor film formed on a bonded substrate comprising a silicon single crystal, wherein

the bonded substrate is a substrate comprising a first silicon single-crystal substrate having a crystal plane orientation of {111} and a second silicon single-crystal substrate having a main surface that has an off-angle with respect to a crystal plane orientation of {100}, the first silicon single-crystal substrate and the second silicon single-crystal substrate being bonded via an oxide film, and

the nitride semiconductor film is formed on a surface of the first silicon single-crystal substrate of the bonded substrate.

[2]: The substrate for an electronic device according to [1] described above, wherein the second silicon single-crystal substrate is nitrogen-doped.

[3]: The substrate for an electronic device according to [1] or [2] described above, wherein

the first silicon single-crystal substrate is formed with a notch in <110> direction,

the second silicon single-crystal substrate is formed with a notch in <110> direction, and

the bonded substrate is a substrate bonded to align a notch position of the first silicon single-crystal substrate and a notch position of the second silicon single-crystal substrate.

[4]: The substrate for an electronic device according to any one of [1] to [3] described above, wherein the bonded substrate has a diameter of 300 mm or larger.

[5]: A method for producing a substrate for an electronic device by forming a nitride semiconductor film on a bonded substrate comprising a silicon single crystal, the method comprising the steps of:

preparing a first silicon single-crystal substrate having a crystal plane orientation of {111}, and a second silicon single-crystal substrate having a main surface that has an off-angle with respect to a crystal plane orientation of {100};

thermally oxidizing at least one of the first silicon single-crystal substrate and the second silicon single-crystal substrate to form an oxide film on a surface;

producing the bonded substrate by laminating the first silicon single-crystal substrate and the second silicon single-crystal substrate via the oxide film and then heat treating to bond the first silicon single-crystal substrate and the second silicon single-crystal substrate; and

epitaxially growing the nitride semiconductor film on a surface of the first silicon single-crystal substrate of the bonded substrate.

[6]: The method for producing a substrate for an electronic device according to [5] described above, wherein the second silicon single-crystal substrate to be prepared is nitrogen-doped.

[7]: The method for producing a substrate for an electronic device according to [5] or [6] described above, wherein

the first silicon single-crystal substrate to be prepared is formed with a notch in <110> direction, the second silicon single-crystal substrate to be prepared is formed with a notch in <110> direction, and the first silicon single-crystal substrate and the second silicon single-crystal substrate are laminated and bonded so as to align a notch position of the first silicon single-crystal substrate and a notch position of the second silicon single-crystal substrate.

[8]: The method for producing a substrate for an electronic device according to any one of [5] to [7] described above, wherein

the first silicon single-crystal substrate and the second silicon single-crystal substrate to be prepared have diameters of 300 mm or larger.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

**Claims**

1.  A substrate for an electronic device, comprising a nitride semiconductor film formed on a bonded substrate comprising a silicon single crystal, wherein

    the bonded substrate is a substrate comprising a first silicon single-crystal substrate having a crystal plane orientation of {111} and a second silicon single-crystal substrate having a main surface that has an off-angle with respect to a crystal plane orientation of {100}, the first silicon single-crystal substrate and the second silicon single-crystal substrate being bonded via an oxide film, and
    the nitride semiconductor film is formed on a surface of the first silicon single-crystal substrate of the bonded substrate.

2.  The substrate for an electronic device according to claim 1, wherein
    the second silicon single-crystal substrate is nitrogen-doped.

3.  The substrate for an electronic device according to claim 1, wherein

    the first silicon single-crystal substrate is formed with a notch in <110> direction,
    the second silicon single-crystal substrate is formed with a notch in <110> direction, and
    the bonded substrate is a substrate bonded to align a notch position of the first silicon single-crystal substrate and a notch position of the second silicon single-crystal substrate.

4.  The substrate for an electronic device according to claim 2, wherein

    the first silicon single-crystal substrate is formed with a notch in <110> direction,
    the second silicon single-crystal substrate is formed with a notch in <110> direction, and
    the bonded substrate is a substrate bonded to align a notch position of the first silicon single-crystal substrate and a notch position of the second silicon single-crystal substrate.

5.  The substrate for an electronic device according to any one of claims 1 to 4, wherein
    the bonded substrate has a diameter of 300 mm or larger.

6.  A method for producing a substrate for an electronic device by forming a nitride semiconductor film on a bonded substrate comprising a silicon single crystal, the method comprising the steps of:

preparing a first silicon single-crystal substrate having a crystal plane orientation of {111}, and a second silicon single-crystal substrate having a main surface that has an off-angle with respect to a crystal plane orientation of {100};

thermally oxidizing at least one of the first silicon single-crystal substrate and the second silicon single-crystal substrate to form an oxide film on a surface;

producing the bonded substrate by laminating the first silicon single-crystal substrate and the second silicon single-crystal substrate via the oxide film and then heat treating to bond the first silicon single-crystal substrate and the second silicon single-crystal substrate; and

epitaxially growing the nitride semiconductor film on a surface of the first silicon single-crystal substrate of the bonded substrate.

7. The method for producing a substrate for an electronic device according to claim 6, wherein
the second silicon single-crystal substrate to be prepared is nitrogen-doped.

8. The method for producing a substrate for an electronic device according to claim 6, wherein

the first silicon single-crystal substrate to be prepared is formed with a notch in <110> direction,
the second silicon single-crystal substrate to be prepared is formed with a notch in <110> direction, and
the first silicon single-crystal substrate and the second silicon single-crystal substrate are laminated and bonded so as to align a notch position of the first silicon single-crystal substrate and a notch position of the second silicon single-crystal substrate.

9. The method for producing a substrate for an electronic device according to claim 7, wherein

the first silicon single-crystal substrate to be prepared is formed with a notch in <110> direction,
the second silicon single-crystal substrate to be prepared is formed with a notch in <110> direction, and
the first silicon single-crystal substrate and the second silicon single-crystal substrate are laminated and bonded so as to align a notch position of the first silicon single-crystal substrate and a notch position of the second silicon single-crystal substrate.

10. The method for producing a substrate for an electronic device according to any one of claims 6 to 9, wherein
the first silicon single-crystal substrate and the second silicon single-crystal substrate to be prepared have diameters of 300 mm or larger.

[FIG. 1]

[FIG. 2]

Cleavage Plane

Off-Angle

Cleavage Plane

Vertical Direction to Main Surface

[FIG. 3]

First Silicon Single-Crystal Substrate
Crystal Plane Orientation: {111}
Notch Position: <110>

Second Silicon Single-Crystal Substrate
Crystal Plane Orientation: {100}
Notch Position: <110>

Laminating
→

Laminating Cleavage Planes of
Silicon Single-Crystal Bonded
Substrate

[FIG. 4]

First Silicon Single-Crystal Substrate
Crystal Plane Orientation: {111}
Notch Position: <110>

Second Silicon Single-Crystal Substrate
Crystal Plane Orientation: {100}
Notch Position: <100>

Laminating Cleavage Planes of
Silicon Single-Crystal Bonded
Substrate

[FIG. 5]

| | |
|---|---|
| Preparing First Silicon Single-Crystal Substrate and Second Silicon Single-Crystal Substrate | S11 |
| Forming Oxide Film | S12 |
| Bonding First Silicon Single-Crystal Substrate and Second Silicon Single-Crystal Substrate | S13 |
| Epitaxially Growing Nitride Semiconductor Film | S14 |

[FIG. 6]

[FIG. 7]

(a)

150 mm

J    J    J

10

N    Lateral Direction

(b)

R:15 mm    J    Testing rate
5 mm/min

R:15 mm    J    N    J    R:15 mm

10

150 mm

## INTERNATIONAL SEARCH REPORT

| International application No. |
|---|
| **PCT/JP2023/006579** |

**A. CLASSIFICATION OF SUBJECT MATTER**

*C30B 25/18*(2006.01)i; *C30B 29/06*(2006.01)i; *C30B 29/38*(2006.01)i; *C30B 33/06*(2006.01)i; *H01L 21/20*(2006.01)i; *H01L 21/205*(2006.01)i

FI: C30B25/18; C30B29/38; C30B33/06; H01L21/20; H01L21/205; C30B29/06 B

According to International Patent Classification (IPC) or to both national classification and IPC

**B. FIELDS SEARCHED**

Minimum documentation searched (classification system followed by classification symbols)

C30B25/18; C30B29/06; C30B29/38; C30B33/06; H01L21/20; H01L21/205; H01L21/02; H01L27/12

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-027186 A (SHIN-ETSU HANDOTAI CO., LTD.) 22 February 2021 (2021-02-22) entire text, all drawings | 1-10 |
| A | JP 2009-231376 A (SHIN-ETSU HANDOTAI CO., LTD.) 08 October 2009 (2009-10-08) entire text, all drawings | 1-10 |
| A | JP 2021-163779 A (SHIN-ETSU HANDOTAI CO., LTD.) 11 October 2021 (2021-10-11) entire text, all drawings | 1-10 |
| A | JP 9-246505 A (HITACHI LTD) 19 September 1997 (1997-09-19) entire text, all drawings | 1-10 |

☐ Further documents are listed in the continuation of Box C.　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 April 2023** | **09 May 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

INTERNATIONAL SEARCH REPORT
Information on patent family members

International application No.

**PCT/JP2023/006579**

| Patent document cited in search report | | | Publication date (day/month/year) | Patent family member(s) | | | Publication date (day/month/year) |
|---|---|---|---|---|---|---|---|
| JP | 2021-027186 | A | 22 February 2021 | US | 2022/0367188 | A1 | |
| | | | | entire text, all drawings | | | |
| | | | | WO | 2021/024654 | A1 | |
| | | | | EP | 4012750 | A1 | |
| | | | | CN | 114207825 | A | |
| JP | 2009-231376 | A | 08 October 2009 | US | 2010/0314722 | A1 | |
| | | | | entire text, all drawings | | | |
| | | | | WO | 2009/116227 | A1 | |
| JP | 2021-163779 | A | 11 October 2021 | (Family: none) | | | |
| JP | 9-246505 | A | 19 September 1997 | (Family: none) | | | |

Form PCT/ISA/210 (patent family annex) (January 2015)

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021014376 A

- JP 2021027186 A